# EUROPEAN PATENT APPLICATION

(11) **EP 1 114 886 A1**
(43) Date of publication of application: **11.07.2001**
(21) Application number: 99937037.2
(22) Date of filing: 11.08.1999
(51) Int. Cl.: C30B 29/58, C07H 21/00, C07K 1/14, C08H 1/00, C12N 9/00

(54) **CRYSTAL GROWING METHOD AND CRYSTAL GROWING APPARATUS**

(30) Priority: 12.08.1998 JP 22787898
(71) Applicant: Sumitomo Metal Industries Limited, Osaka-shi, Osaka 541-0041 (JP)
(72) Inventor: SANJOH, Akira, Sumitomo Metal Ind. Ltd., Amagaseki-shi, Hyogo 660-0891 (JP)
(74) Representative: Stuart, Ian Alexander
(86) International application number: JP9904360
(87) International publication number: WO0009785

(57) **Abstract**

An apparatus for crystal growth includes a solid-state component (42) having a region (42a) whose valence electrons have been controlled so as to control the concentration of holes or electrons of a surface portion in response to the environment of a solution (43) containing a macromolecular compound, a pair of counter electrodes (44a) and (44b) provided to hold therebetween a space above the region (42a), and electric insulating materials (46a) and (46b) supporting the counter electrodes (44a) and (44b). The region (42a) is an impurity region formed on a silicon semiconductor substrate. In the crystal growth method, an electric field is applied to the solution (43) across the counter electrodes (44a) and (44b). Under an electric state generated on the surface of the region (42a), a crystal of the macromolecular compound is formed from the solution (43) to which the electric field is applied.

## Description

### Technical Field

The present invention relates to a method and an apparatus for growing a crystal of a chemical substance, and more particularly, it relates to improvements of a method and an apparatus for growing a crystal of an organic compound or the like with a solid-state component having a region in which valence electrons are controlled and which comprises an impurity-doped semiconductor or the like.

### Background Art

In a conventional process for crystallization of a biological macromolecule such as protein, a treatment for eliminating a solvent from an aqueous or non-aqueous solution containing the macromolecule is basically carried out, so that the resulting supersaturated state can reduce the solubility, leading to crystal growth. As typical methods thereof, a batch method, dialysis, and vapor-liquid interdiffusion are known. These methods are selected and used depending upon the type, quantity, property, and the like of the sample.

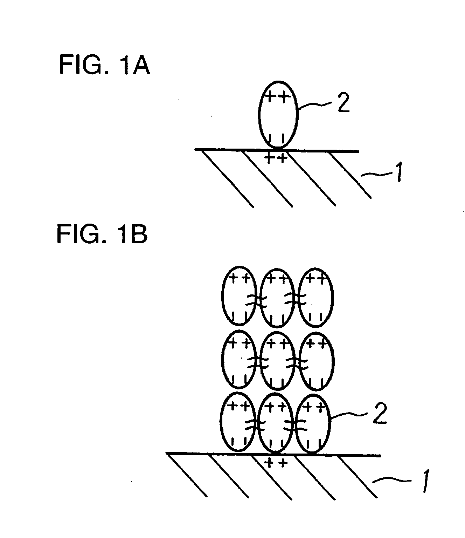

As a new method substituting for these methods, or as a method for more efficiently growing a crystal in combination with these methods, the inventor has developed a method and an apparatus for performing crystallization with a semiconductor substrate or the like whose valence electrons are controlled (refer to International Laying-Open Gazettes WO96/26781, WO97/49845 and WO98/02601). In this method, as shown in Fig. 1A, a crystal nucleus 2 is fixed by electrostatic action to the surface of a solid-state component 1 brought into a prescribed electric state by valence electron control. As shown in Fig. 1B, compounds such as protein aggregate on the solid-state component surface by electrostatic interaction, generation of crystal nuclei is promoted, and a crystal grows. Therefore, the crystallization can be controlled by controlling electric characteristics of the solid-state component surface. For example, the type, quantity, arrangement density or the like of the crystal nuclei fixed on the solid-state component surface can be adjusted by valence electron control, whereby the crystallization can be controlled.

In general, a biological macromolecule such as protein has an extremely large molecular weight and a small self-diffusion coefficient in a solution, so that aggregation or association of the molecules necessary for crystal nucleation hardly takes place. This is a factor in the difficulty of crystallization of a biological macromolecule such as protein.

### Disclosure of Invention

An object of the present invention is to improve the method and apparatus employing a solid-state component having a region where valence electrons are controlled for control of crystallization, and to provide a method and an apparatus which can produce crystallization more readily or more quickly.

Another object of the present invention is to improve the methods and the apparatuses disclosed in Internal Application Gazettes WO96/26781, WO97/49845 and WO98/02601 and to provide a method and an apparatus which can produce crystallization more readily or more quickly.

The present invention is directed to a method of growing a crystal of a macromolecular compound contained in a solution, which comprises the steps of: providing a solid-state component having a region whose valence electrons has been controlled so as to control the concentration of holes or electrons on a surface portion of the region in response to the environment of the solution containing the macromolecular compound; holding the solution containing the macromolecular compound on the region of the solid-state component whose valence electrons are controlled; and applying an electric field to the held solution across a pair of opposed electrodes. In this method, a crystal of the macromolecular compound is formed from the solution to which the electric field is applied under an electric state generated on the surface of the solid-state component by the controlled valence electrons.

In a preferred mode, the method according to the present invention comprises the steps of: providing a solid-state component in which the concentration of holes or electrons present at a surface thereof has been controlled or a solid-state component which has been modified to have regions of varying electric potentials on a surface thereof; holding a solution containing a macromolecular compound on the surface of the solid-state component; and applying an electric field to the held solution across a pair of opposed electrodes. Under the electric potentials generated on the surface of the solid-state component, a crystal of the macromolecular compound is formed from the solution to which the electric field is applied.

In another preferred mode, the method according to the present invention comprises the steps of: doping a surface of a solid-state component with a dopant to modify the concentration of holes or electrons present at the surface of the solid-state component; holding a solution containing a macromolecular compound on the surface of the solid-state component; and applying an electric field to the held solution across a pair of opposed electrodes. Under an electric potential generated on the surface of the solid-state component, a crystal of the macromolecular compound is formed from the solution to which the electric field is applied.

In the method according to the present invention, the region whose valence electrons are controlled, such as the region in which the concentration of holes or electrons has been controlled or the region whose surface potential has been controlled, may comprise a semiconductor to which an impurity is added.

The present invention is also directed to an apparatus for crystal growth, which comprises: a solid-state component having a region whose valence electrons have been controlled so as to control the concentration of holes or electrons on a surface portion of the region in response to the environment of a solution containing a macromolecular compound; a pair of opposed electrodes provided to hold therebetween a space above the region whose valence electrons has been controlled; and an electric insulating material provided between the solid-state component and the pair of opposed electrodes.

In a preferred mode, the apparatus according to the present invention comprises: a solid-state component in which the concentration of holes or electrons present at a surface thereof has been controlled or a solid-state component which has been modified to have regions of varying electric potentials on a surface thereof; a pair of opposed electrodes provided to hold therebetween a space above the surface; and an electric insulating material provided between the solid-state component and the pair of opposed electrodes.

In the apparatus according to the present invention, a space for holding the solution containing the macromolecular compound can be formed by the pair of opposed electrodes; the electric insulating material; and the region whose valence electrons have been controlled, such as the region in which the concentration of holes or electrons has been controlled or the region whose surface potential has been controlled.

In the apparatus according to the present invention, the pair of opposed electrodes may made of a electrically conductive material in the form of a thin film.

In the apparatus according to the present invention, the region whose valence electrons have been controlled, such as the region in which the concentration of holes or electrons has been controlled or the region whose surface potential has been controlled, may comprise a semiconductor to which an impurity is added.

### Brief Description of Drawings

Fig. 1A and Fig. 1B are model diagrams showing such a situation that crystal nuclei are fixed to the surface of the solid-state component where valence electrons are controlled and crystal growth proceeds.

Fig. 2A is a model diagram showing such a situation that the molecules to be crystallized aggregate on a valence electron-controlled solid-state component with no electric field applied to a solution containing the molecules, and Fig. 2B is a model diagram showing that the movement of the molecules to the solid-state component is promoted by applying an electric field to the solution.

Fig. 3 is a diagram schematically showing the relation between the sizes of crystal nuclei from nucleation to crystal growth and free energy.

Fig. 4 is a sectional view showing an example of the apparatus for crystal growth according to the present invention.

Fig. 5A is a plan view showing another apparatus for crystal growth according to the present invention, and Fig. 5B is an X-X sectional view thereof.

Fig. 6A is a plan view showing still another apparatus for crystal growth according to the present invention, Fig. 6B is an X-X sectional view thereof, and Fig. 6C is a sectional view showing an electrode structure.

Figs. 7A and 7B are sectional views showing another electrode structure employed for the present invention.

Figs. 8A to 8D are diagrams schematically showing a fabrication process for electrode units employed in the present invention.

Fig. 9 is a perspective view showing a situation of superposing an electrode unit obtained through the process shown in Fig. 8A to Fig. 8D with an electric insulating material.

Figs. 10A and 10B are perspective views showing a process of superposing a plurality of electric insulating materials and then forming a thin-film electrode on the superposed body.

Fig. 11 is a diagram schematically showing another example of the apparatus for crystal growth according to the present invention.

Fig. 12A is a diagram schematically showing an example of the apparatus for crystal growth according to the present invention having a through hole, and Fig. 12B is an X-X sectional view thereof.

Fig. 13 is a model diagram showing a situation of applying voltage to the apparatus for crystal growth having a through hole shown in Fig. 12A and Fig. 12B.

Fig. 14 is a model diagram showing a further apparatus for crystal growth according to the present invention.

Fig. 15 is a sectional view showing a detailed structure of the apparatus shown in Fig. 14.

Fig. 16 is a sectional view schematically showing a further apparatus for crystal growth according to the present invention.

Fig. 17 is a plan view showing a structure arranging, on a plate, a large number of the apparatuses of the present invention each comprising a pair of electrodes and a solid-state component and applying voltage thereto.

Fig. 18 is a sectional view showing one of the apparatuses shown in Fig. 17.

Fig. 19 is a plan view showing such a situation that a large number of solid-state components are formed on a silicon wafer.

Figs. 20A to 20C are plan views showing apparatuses for crystal growth obtained by combining the solid-state elements obtained by cutting the silicon wafer shown in Fig. 19 with electrode units.

Fig. 21 is an enlarged plan view of an apparatus further comprising heating elements based on the apparatuses for crystal growth shown in Figs. 20A to 20C.

Fig. 22 is a model diagram showing the structure of the heating element shown in Fig. 21 in an enlarged manner.

Referring to the drawings, 40, 50 and 60 denote apparatuses for crystal growth, 42, 52 and 62 denote solid-state components, 44a, 44b, 54a, 54b, 64a, 64b, 64'a and 64b' denote electrodes, and 46a, 46b, 56a, 56b, 66a and 66b denote electric insulating materials respectively.

### Best Modes for Carrying Out the Invention

As described below, the present invention facilitates or promotes the formation of crystal nuclei.

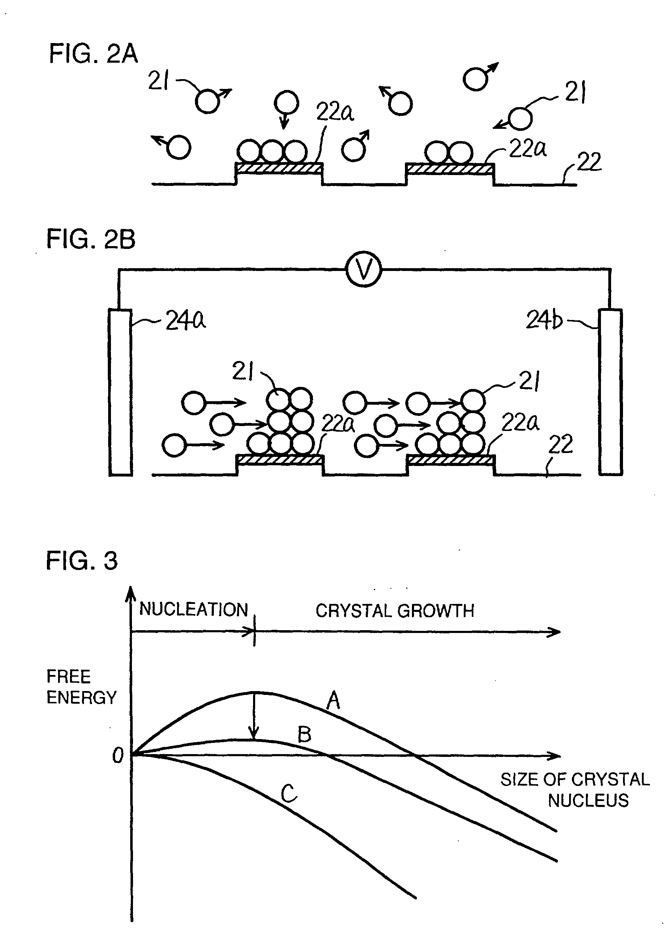

In a mechanism that contributes to the crystal growth process, the molecules move to a crystal surface from a place at a considerable distance from the crystal seed by diffusion in the solution. As shown in Fig. 2A, when a solution containing molecules 21 such as protein to be crystallized is allowed to stand on a solid-state component 22 having regions 22a whose valence electrons are controlled (e.g., a substrate comprising a semiconductor such as silicon in which valence electrons are controlled by doping), the molecules 21 are electrostatically fixed to the regions 22a depending on the diffusion kinetics of the molecules 21. Each of the specific regions 22a allows the molecules 21 to aggregate thereon, and contributes to crystallization of the molecules 21. When each of the molecules 21 has an extremely large molecular weight, however, the diffusion coefficient thereof in the solution is so small that the molecules 21 cannot sufficiently move to the regions 22a. In this case, the molecules 21 hardly aggregate on the regions 22a, and it takes much time to form crystal nuclei. In the present invention, as shown in Fig. 2B, a pair of electrodes 24a and 24b are provided in the environment for crystal growth, and voltage is applied across the electrodes. The molecules 21 in the solution are electrophoresed in the applied electric field. In particular, charged molecules come to remarkably move by the electric field. By the increase in the moving rate of the molecules, the distant molecules can be involved in the aggregation on the regions 22a and the formation of crystal nuclei. Thus, a large number of the molecules can aggregate on the regions 22a in a relatively short time, so that the formation of crystal nuclei is promoted.

Fig. 3 schematically shows the change of free energy during crystallization. In the graph, the vertical axis represents free energy, and the horizontal axis represents the size of crystal nuclei. Curve A shows the case of allowing the solution to stand during crystallization, curve B shows the case of applying an electric field during crystallization according to the present invention, curve C shows the case where no growth of a crystal takes place (such as the case where an amorphous body or a mere molecular aggregate is formed). As shown with the arrow from curve A to B, it is possible to promote movement (migration) of the molecules and lower an energy barrier of nucleation according to the present invention. In other words, activation energy for nucleation can be reduced.

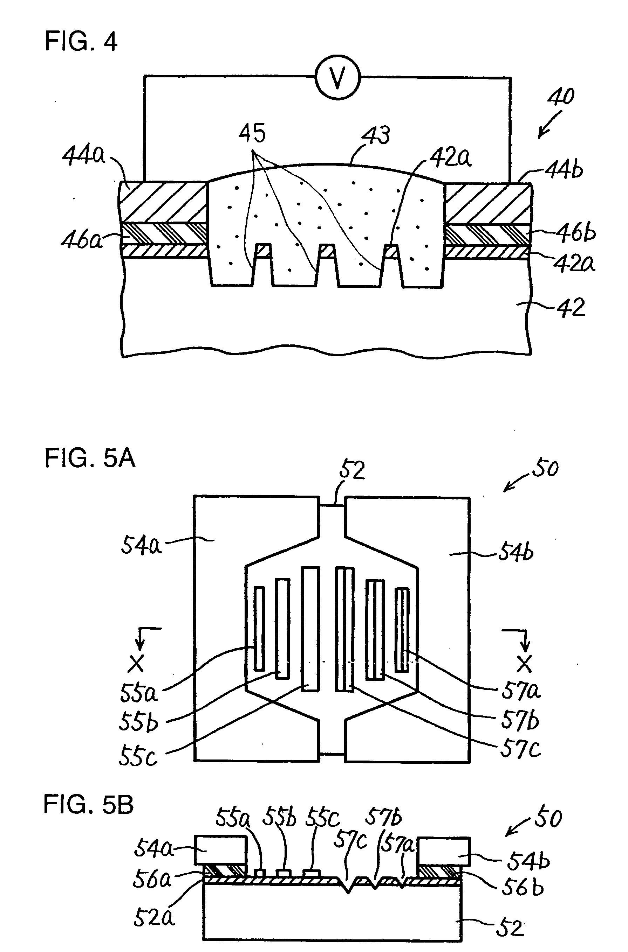

A crystal growth apparatus according to the present invention may have a structure shown in Fig .4. A crystal growth apparatus 40 includes a solid-state component 42, electric insulating materials 46a and 46b and a pair of counter electrodes 44a and 44b. The solid-state component 42 has regions 42a whose valence electrons are controlled (such as impurity regions formed on a semiconductor such as silicon). Further, the solid-state component 42 is formed to have a groove or grooves, a hole or holes, an island or islands, or the like for controlling crystallization as needed. For example, the apparatus as shown in Fig. 4 has a plurality of islands 45 formed. The top of the islands and the vicinity of the top form the region 42a having valence electrons controlled. The pair of counter electrodes 44a and 44b are provided on the solid-state component 42 through the electric insulating materials 46a and 46b. The electric insulating materials 46a and 46b are provided for preventing the electrodes 44a and 44b from being short-circuited through the solid-state component 42. The electric insulating materials 46a and 46b are also provided not to exert electric influence from the electrodes 44a and 44b to the regions 42a having valence electrons controlled. In addition, the electric insulating materials 46a and 46b can serve as a support for the electrodes 44a and 44b on certain regions of the solid-state component 42. The electrodes 44a and 44b are provided to hold therebetween a space for performing crystallization. A solution 43 containing the molecule to be crystallized such as protein is stored between the electrodes 44a and 44b on the solid-state component 42. The solution 43 can be stored in a prescribed region of the solid-state component 42, particularly in a space surrounded by the electric insulating materials 46a and 46b and the electrodes 44a and 44b arranged to encompass the island 45.

Voltage is applied across the electrodes 44a and 44b of the apparatus 40. The voltage is preferably applied particularly in an initial stage of crystal growth, i.e., the stage of crystal nucleus formation. Both of dc voltage and ac voltage is available. When dc voltage is applied, the direction of the electric field is preferably changed in a prescribed cycle. When sufficient crystal nuclei are formed, application of the voltage may be stopped. The magnitude of the voltage may be set in the range of several 10 V to several 100 V. The voltage application time can be set from several hours to several days depending on the crystallization conditions. The molecules to be crystallized in the solution can be electrophoresed by application of the electric field, so that the migration length of the molecules increases. Therefore, collision of the molecules readily takes place in the solution, and the formation of crystal nuclei is promoted.

In the crystal growth process according to the present invention, the electric field may be applied to the solution from the start of crystallization to the stage of the crystal nucleus formation, and the application of the electric field can be stopped at the time when the crystal nuclei are formed. The timing for stopping the application of the electric field can be managed by time. For example, the voltage may be kept ON for a prescribed time period from the start of crystallization, and the voltage may be OFF when the prescribed time passes. In advance, crystal nucleus formation time may be measured on a test sample to set the time period of the voltage application. In such a test, the process of the crystallization can be observed with a microscope to measure the crystal nucleus formation time. The time period measured can be employed for the control of the voltage application.

The present invention employs a solid-state component having a region whose valence electrons have been controlled so as to control the crystallization thereon. Such a solid-state component is disclosed in WO96/26781, WO97/49845 and WO98/02601. Typically, the region whose valence electrons have been controlled consists essentially of a semiconductor to which an impurity is added in a prescribed concentration. The semiconductor includes simple substance semiconductors such as Ge and Si and compound semiconductors such as Ga-As and CdS. The present invention may employ other materials as far as valence electrons can be controlled in such materials. Such available materials include ferroelectric substances such as barium titanate and strontium titanate as well as other inorganic or organic materials in which valence electron can be controlled.

The semiconductor material having valence electrons controlled may have a p-n junction part. A space charge layer may also be formed in the material having valence electrons controlled such that the crystallization can be controlled by a surface potential based on the space charge layer. The surface potential may vary over the surface portion of the solid-state component, so that the desired crystallization can be induced on a specific region of the surface. The surface potential or the electric state of the surface of the solid-state component can be controlled by the concentration of an impurity doped into the solid-state component. In the surface portion of the solid-state component, the concentration of the impurity may be reduced or increased continuously or stepwise from a first prescribed region to a second prescribed region. In the surface portion of the solid-state component, the impurity concentration can also be maximal or maximum or minimal or minimum at a specific region.

In the present invention, the solid-state component may have a plurality of grooves or holes. The plurality of the grooves or holes may have different depths and/or widths of the opening. In the solid-state component, the inside of the grooves or holes may differ from the out side thereof in the valence electrons controlled. For example, in the solid-state component employing a semiconductor substrate, the inside of the grooves or holes formed on the semiconductor substrate may differ from the out side thereof in the type and/or concentration of the impurity doped. Further, a water-repellent layer may be provided on the solid-state component to surround the plurality of grooves or holes formed thereon.

In the present invention, the solid-state component may have two opposed principal surfaces, at least two grooves or holes having different depths and/or widths of the openings formed on one surface of the two principal surfaces, and a through hole for supplying the solution containing the macromolecular compound to the grooves or holes from the side of the other surface of the two principal surfaces. In this solid-state component, valence electrons are controlled so that the crystallization of the macromolecular compound is promoted rather inside than outside the grooves or holes. Such a solid-state component may employ an impurity-added semiconductor substrate. The semiconductor substrate is formed to have a plurality of grooves or holes having different sizes, and the inside of the grooves or holes differs from the outside thereof in the type and/or concentration of the impurity.

The apparatus for crystal growth employed for the present invention may include: a plurality of the solid-state components having at least two grooves or holes with different depths and/or widths of the openings; and means for holding the plurality of the solid-state components opposed to each other with a prescribed clearance therebetween. In this apparatus, a solution containing molecules to be crystallized is held between the opposed solid-state components.

The apparatus employed for the present invention may have a plurality of solution storage parts for holding solutions necessary for crystal growth and a passage provided between the plurality of the solution storage parts. Such solution storage parts and a passage may be provided on the substrate having a region whose valence electrons have been controlled. At least one of the plurality of the solution storage parts has the region whose valence electrons have been controlled and crystallization is carried out in this region. For example, the apparatus for crystal growth may have a plurality of first solution storage parts for holding at least two types of solutions respectively, a plurality of second solution storage parts for keeping a solution containing a macromolecular compound to induce crystal growth, and a plurality of passages connecting the plurality of the first solution storage parts to the plurality of second solution storage parts for the circulation of the solutions. At least in the second solution storage part, valence electrons are controlled for the control of the crystallization. In particular, valence electrons are preferably controlled so that crystal nucleus formation and crystal growth are facilitated at a specific region of the second solution storage part while crystal nucleus formation is suppressed in the other region. In such a case, a crystal can be selectively grown at the specific region of the second solution storage part. The region where valence electrons are controlled may comprise a semiconductor to which an impurity is added. The second solution storage part may also be formed with a groove or hole.

In another mode, the apparatus for crystal growth employed for the present invention may comprise: a plurality of first solution storage parts for holding at least two types of solutions respectively; a plurality of first passages for discharging the solutions from the plurality of the first solution storage parts respectively and feeding the same in a direction; a second solution storage part simultaneously receiving at least two types of the solutions fed by the plurality of the first passages respectively; a second passage for discharging the solution from the second solution storage part and feeding the same in a direction; and a third solution storage part receiving the solution fed by the second passage. At least in the second solution storage part, valence electrons have been controlled for crystallization. The first passages and/or the second passage may be a groove formed on a substrate. These solution storage parts may also be formed on the substrate. The groove may have a stepwise shape or a gradient for feeding the solution in one direction. The first passages or the second passage may also be composed of a plurality of grooves having different widths and depths formed on the substrate. It is preferable that the width of each groove increases as going from the upstream to the downstream, and the depth of each groove increases as going from the upstream to the downstream. In this apparatus, the region where valence electrons are controlled may comprise a semiconductor to which an impurity is added. Also in this apparatus, valence electrons may be controlled so that crystal nucleus formation and crystal growth are facilitated at a specific region of the second solution storage part while crystal nucleus formation is suppressed in the other region.

In still another mode, the apparatus for crystal growth employed for the present invention comprises a substrate having a pair of opposed main surfaces and having a region whose valence electrons are controlled, wherein the substrate comprises: a first solution storage part, provided on one of the pair of the main surfaces, for holding a solution employed for crystal growth; a passage, provided on one of the pair of the main surfaces, for discharging the solution from the first solution storage part and feeding the same in a prescribed direction; a second solution storage part, provided on one of the pair of the main surfaces, for receiving the solution fed from the passage; a through hole for directing the solution present in the second solution storage part to the other one of the pair of the main surfaces; and a third solution storage part for receiving the solution fed through the through hole at the other one of the pair of the main surfaces. At least in the second solution storage part and/or the third solution storage part of the substrate, valence electrons have been controlled for crystallization. In this apparatus, the passage may be composed of a plurality of grooves having different widths and/or depths. The diameter of the through hole for feeding the solution from the second solution storage part to the third solution storage part may be varied with crystal growth conditions. The second solution storage part may be formed to have a groove or a hole. Valence electrons may be controlled so that crystal nucleus formation and crystal growth are facilitated at a specific region of the second solution storage part and/or the third solution storage part and crystal nucleus formation is suppressed in the other region. Typically, the region whose valence electrons are controlled comprises a semiconductor to which an impurity is added. Valence electrons can be modulated by the control of the concentration and/or the type of the impurity.

In the present invention, n-type and p-type silicon crystals are preferably employed as the material for the solid-state component. The characteristics of the silicon crystal employed may be equivalent to those of the silicon employed for a general LSI process. The specific resistance of the silicon crystal employed may be in the range of about 0.0001 to 1000 Ωcm, preferably in the range of 0.001 to 100 Ωm. Various methods may be used to obtain the silicon having valence electrons controlled into an n-type or a p-type. Ion implantation is one of such methods, which is simplest and can correctly modulate the impurity concentration. Valence electron control into p-type or n-type can readily be made by injecting ions of elements belonging to group III or group V of the periodic table into silicon and annealing the same. The group III elements for p-type include B, Al, Ga, In, Tl an the like. In particular, B is generally used. The group V elements for n-type include N, P, As, Sb and Bi. In particular, P, As or Sb is generally used. The surface of the silicon crystal is preferably mirror-polished. The thickness of the impurity layer formed at the surface of the silicon substrate is preferably 1 to 200 µm, more preferably 1 to 50 µm. A semiconductor crystal other than silicon may also be preferably employed for the present invention. Alternatively, materials other than the semiconductor crystal, such as an inorganic compound, an organic compound, a polymer compound or composites thereof, whose charge distribution is controlled or modified, may be a potential material for the present invention. The size of the opening and the depth of the groove or hole formed on the substrate may be set in any preferable range depending on the type of the molecule to be crystallized. Generally, the groove or hole has a width of the opening from 0.01 to 100 µm and the groove has a length from 1 to 10 mm. A plurality of the grooves or holes may be formed at intervals in the range of 1 µm to 1 mm. The depth of the groove or hole may be 0.01 to 200 µm. The thickness of the water-repellent layer formed to surround the solution storage part or the passages may be 0.1 to 100 µm. The water-repellent layer contributes to holding of the solution. The water-repellent layer may be made of water-repellent resin such as polyimide.

The region whose valence electrons are controlled for crystallization, the grooves, the holes, the islands, the solution storage parts, the passages for the solution and other structures provided as needed may be provided according to the disclosures of WO96/26781, WO97/49845 and WO98/02601. As to the structure of the solid-state component employed in the present invention and a method of fabricating the same, WO96/26781, WO97/49845 and WO98/02601 are incorporated herein by reference.

Examples of the apparatus for crystal growth according to the present invention are shown below.

Referring to Figs. 5A and 5B, an apparatus 50 for crystal growth has a solid-state component 52, electric insulating layers 56a and 56b provided thereon, and a pair of counter electrodes 54a and 54b provided on the insulating layers. A region 52a where valence electrons are controlled is formed on a surface portion of the solid-state component 52. The solid-state component 52 has projections 55a, 55b and 55c having different widths and lengths, and V-shaped grooves 57c, 57b and 57a having different widths and depths. These projections and grooves are arranged at prescribed intervals. Typically, in the solid-state component 52, the body is a p-type silicon substrate, the region 52a having valence electrons controlled is an n-type silicon layer formed on the silicon substrate, and the projections 55a to 55c are p-type silicon layers formed on the silicon substrate. The p-type silicon is exposed at the bottoms of the groove 57a to 57c. The electrodes 54a and 54b are provided to surround the region 52a having valence electrons controlled with the projections and grooves formed. The insulating layers 56a and 56b support the electrodes 54a and 54b on the solid-state component 52. The thickness of these electrodes is 0.5 to 1 mm, for example. The electrodes are made of a good conductor such as gold, copper or aluminum. The insulating layers are made of an electric insulating material such as glass, ceramics or resin. A solution containing a molecule to be crystallized is held in a space enclosed with the electrodes 54a and 54b, and the electric insulating materials 56a and 56b. The region for holding the solution can be defined by opposing U-shaped electrodes. In the crystal growth process, voltage is applied across the electrodes 54a and 54b, so that a crystal nucleus is generated from the solution held on the controlled valence electron region 52a having the projections and the grooves. A preferable voltage applied is ac voltage, or such dc voltage that the polarity is exchanged between positive and negative desired times before a crystal nucleus is produced. The application of the voltage may be stopped when a crystal nucleus is formed. The crystal grows on the projections 55a, 55b or 55c or in the grooves 57a, 57b or 57c of the controlled valence electron region 52a.

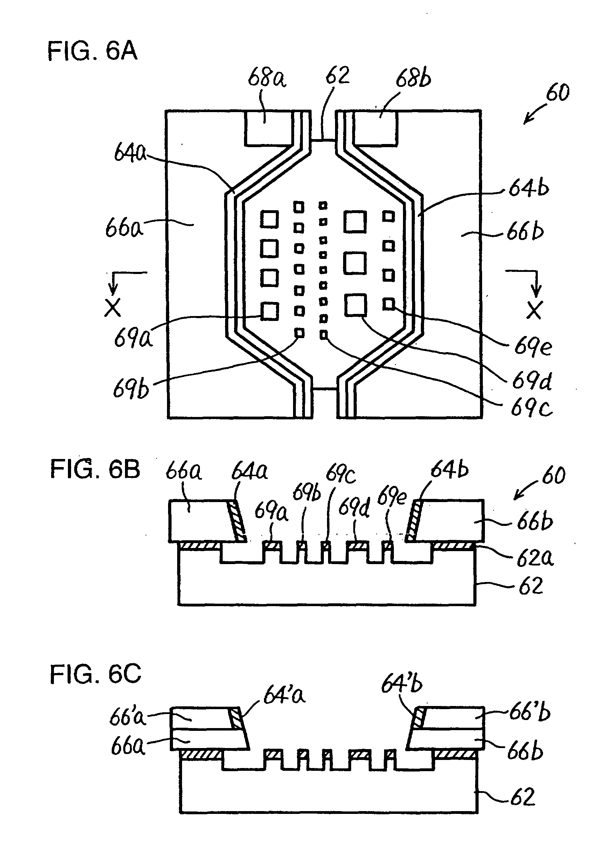

Referring to Figs. 6A and 6B, an apparatus 60 for crystal growth employs thin-film electrodes. In the apparatus 60, a solid-state component 62 has a region 62a doped with an impurity, where a number of islands 69a, 69b, 69c, 69d and 69e having different sizes are formed. In the solid-state component 62, the main body is an n-type silicon substrate, and the controlled valence electron region 62a is a p-type silicon layer formed on the silicon substrate, for example. Surface portions of the islands 69a to 69e are also of p-type. Base materials 66a and 66b for electrodes are provided on the solid-state component 62. Thin-film electrodes 64a and 64b are attached to the forward ends of the respective base materials 66a and 66b for electrodes. The forward ends of both of the base materials 66a and 66b project toward the islands on the solid-state component 62, and the thin-film electrodes 64a and 64b are arranged to surround the controlled valence electron islands. The base materials 66a and 66b are present between the thin-film electrodes 64a and 64b and the solid-state component 62 to break electric connection therebetween. In other words, the thin-film electrodes 64a and 64b are electrically insulated from the solid-state component 62. The base materials 66a and 66b are made of an electric insulating material such as glass or ceramics. The thin-film electrodes 64a and 64b are made of a good conductor such as gold, copper or aluminum. The base materials 66a and 66b are provided with pads 68a and 68b respectively. Through these pads, voltage is applied from an external power source across the electrodes 64a and 64b. In the apparatus 60, a solution containing a molecule to be crystallized is held in the portion enclosed with the electrodes 64a and 64b on the controlled valence electron region 62a having the number of islands. An electric field is applied to the stored solution by the opposed electrodes 64a and 64b. A crystal nucleus can be formed on any proper island under the electric field. The external power source for applying the voltage across the electrodes 64a and 64b is preferably an ac power source, or a dc power source with switching between positive and negative polarities, i.e., a dc power source which is equipped with a switching means to change the direction of the electric field produced.

Fig. 6C shows another electrode structure. A thin-film electrode 64'a is formed on a base material 66'a. Similarly, a thin-film electrode 64'b is formed on a base material 66'b. The base materials 66'a and 66'b are a semi-conductive base material such as silicon or an electric insulating material such as glass. The base materials formed with the thin-film electrodes are supported by electric insulating materials 66a and 66b on a solid-state component 62. The electric insulating materials are glass, ceramics, resin or the like. Such an electrode structure is suitable for forming thin-film electrodes with relatively thin base materials easy to work. The superposing of the base materials for electrodes on the insulating materials may provide a bulky or thick structure to form an enlarged space for storing the solution. A silicon substrate, which is excellent in workability, is suitable as the substrate for the thin-film electrodes. When the thin-film electrodes are formed on the silicon substrate, an electric insulating material such as glass or ceramics is interposed between the solid-state component and the silicon substrate formed with the thin-film electrodes. The thin-film electrodes and the solid-state component are electrically isolated by interposing the electric insulating materials. In the electrode structures as shown in Figs. 6B and 6C, the thickness of the base materials supporting the electrodes or superposed with the insulating materials is typically about 0.5 to 1 mm. The structures having such a thickness around the controlled valence electron region can provide a sufficient amount of the solution stored between the electrodes.

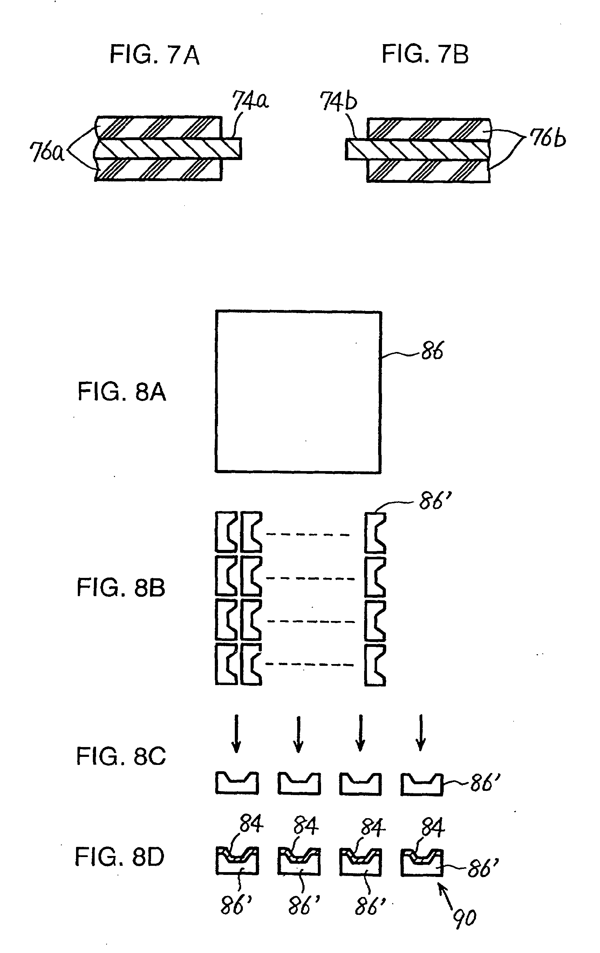

The electrode structure as shown in Figs. 7A and 7B may be also employed. Opposed electrodes 74a and 74b are coated with insulating materials 76a and 76b respectively. The forward ends of the respective electrodes project from the forward ends of the coatings.

The thin-film electrodes are fabricated as shown in Figs. 8A to 8D, for example. First, a material 86 for supporting thin-film electrodes is prepared, as shown in Fig. 8A. Typically, the material 86 is an electric insulating material such as glass or a semi-conductive material such as a silicon wafer. As shown in Fig. 8B, mechanical working, etching or the like of the material 86 is done to give base materials 86' for electrodes having a desired shape. In the step as shown in Fig. 8C, an electrode material is deposited on the respective materials 86' obtained. A general thin film forming method is employed in this step. For example, physical deposition such as sputtering is preferably employed. One of the preferable electrode materials is Au which is insoluble in electrolytic solutions and has a high conductivity. Preferably, Au is deposited on the base material via a priming layer made of Ti, Cr or the like which is formed directly on the base material. Au may be provided directly on the priming layer, or provided on the priming layer via an intermediate conductive layer made of Cu, Ni or the like. Ti and Cr can strongly adhere to the base material of silicon, glass or the like. Au can more strongly adhere to the priming layer than to the base material of silicon or glass. In addition, the use of the intermediate conductive layer of Cu or Ni can provide an increased thickness of the electrically conductive layer. In particular, Cu is advantageous for soldering of wires. For example, the structure of the thin-film electrode to be deposited on the base material may be as follows:
Ti (100 to 2000 Å)/Au (at least 1.0 µm)
Ti (100 to 2000 Å)/Cu (1000 to 5000 Å)/Au (at least 1.0 µm)
Cr (100 to 2000 Å)/Cu (1000 to 5000 Å)/Au (at least 1.0 µm)
Ti (100 to 2000 Å)/Ni (1000 to 5000 Å)/Au (at least 1.0 µm)
Cr (100 to 2000 Å)/Ni (1000 to 5000 Å)/Au (at least 1.0 µm)
The thickness of the layer is provided in the parentheses.

As shown in Fig. 8D, the aforementioned process gives electrode units 90 each including the base material 86' and a thin-film electrode 84 formed thereon.

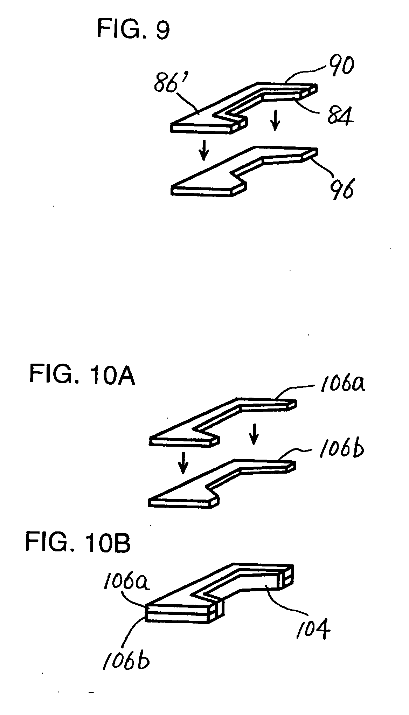

Such an electrode unit may be employed as it is, as shown in Fig. 6B, or may be employed in combination with an electric insulating material as shown in Fig. 6C. As shown in Fig. 9, when the base material 86' is a semi-conductive material such as silicon, the electrode unit 90 is preferably superposed on an electric insulating material 96 having a similar shape thereto. Such a structure prevents the short-circuiting across the electrode and the solid-state component and provides an increased amount of the solution held between the electrodes.

On the other hand, as shown in Fig. 10A, a plurality of base materials 106a and 106b worked into a desired shape may be superposed, and then as shown in Fig. 10B, a thin-film electrode 104 may be formed on the superposed base materials. Such a process gives a thicker base material having the thin-film electrode formed thereon.

The electrode units described above are provided on the solid-state component for crystallization disclosed in WO96/26781, WO97/49845 and WO98/02601. A pair of electrode units are provided to hold therebetween a solution for crystallization in the solid-state component. The electrode units may be mounted on the solid-state component, or may be bonded to the solid-state component with an electrically insulating adhesive. Specifically, the electrode units are arranged on the solid-state component disclosed in the above gazettes as shown below.

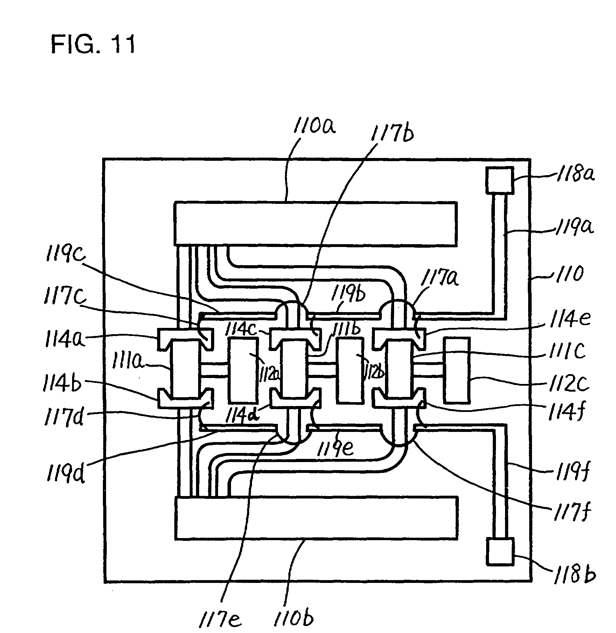

In the apparatus for crystal growth shown in Fig. 11, two solution cells 110a and 110b, three reaction cells 111a, 111b and 111c and two discharge cells 112a, 112b and 112c connect by passages. The cells and the passages are formed on a silicon substrate 110. The passages are formed to feed a solution from the solution cells to the reaction cells and from the reaction cells to the discharge cells. In order to obtain each of the solution cells 110a and 110b, etching is done to form a V-shaped groove around a region of a prescribed size so that the region is separated from the other region. In order to obtain the reaction cells 111a, 111b and 111c, V grooves are formed around regions of a prescribed size by etching, and these regions of the prescribed size are further anisotropically etched to a prescribed depth. Regions of a prescribed size are also anisotropically etched to give the discharge cells. In the silicon substrate 110, a p-type silicon layer of low resistance (specific resistance: about 0.01 Ω·cm, thickness: about 5 µm) is formed on the surface of an n-type silicon substrate of about 30 Ω·cm in specific resistance by ion implantation of a phosphorus element and annealing. Further, a silicon oxide layer of 200 nm in thickness is formed on the surface by thermal oxidation. In each reaction cell, a region of a thin p-type layer having a prescribed width is exposed by etching. On the silicon substrate 110, pads 118a and 118b and wiring layers 119a, 119b, 119c, 119d, 119e and 119f are also formed. A pair of electrode units 114a an 114b are provided on both sides of the reaction cell 111a, a pair of electrode units 114c and 114d are provided on both sides of the reaction cell 111b, and a pair of electrode units 114e an 114f are provided on both sides of the reaction cell 111c. The wires 119a to 119c are connected by bonding wires 117a and 117b. The wiring layers 119d to 119f are also connected by bonding wires 117e and 117f. The wiring layers 119c and 119d are connected to the electrode units 114a and 114b by bonding wires 117c and 117d respectively. Similarly, the remaining electrode units are also connected with the remaining wiring layers by bonding wires. When the pads 118a and 118b are connected to an external power source, voltage is applied across the pair of electrodes through each wiring layer and each bonding wire. The electric field is applied to the solution held in each reaction cell for the acceleration of the crystal nucleus formation.

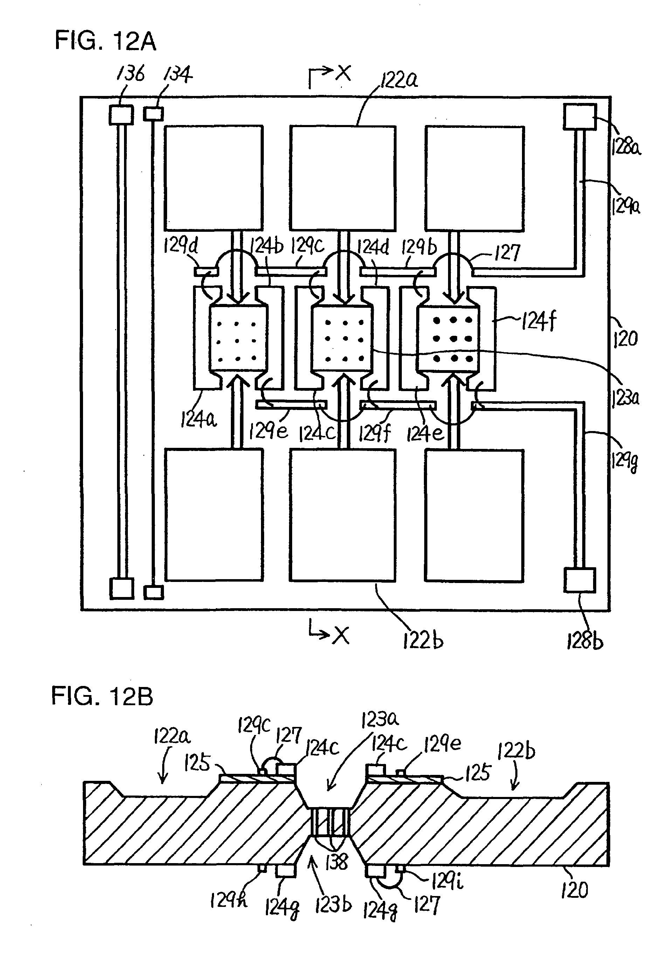

In the apparatus shown in Figs. 12A and 12B, a plurality of solution cells 112a and 112b and a plurality of reaction cells 123a are formed on the surface of a substrate 120. Passages are formed between these solution cells and reaction cells, and these passages enable the movement of a solution from the solution cells to the reaction cells. As shown in Fig. 12B, the solution cells 112a and 112b and the reaction cells 123a are reentrants or holes formed on the substrate 120. The passages are formed by working films 125 provided on the substrate 120. As shown in Fig. 12B, a reaction cell 123b is further formed on the back surface of the substrate 120 at a position opposed to the reaction cell 123a. The reaction cell 123b is also a reentrant or a hole formed on the substrate 120. A plurality of through holes 138 are formed between the reaction cell 123a and the reaction cell 123b. The through holes 138 enable liquid circulation between the front and back surfaces of the substrate. Each reaction cell is formed with a plurality of through holes having different sizes. Further, an electrode 136 for heating and an electrode 134 for temperature measurement are provided on an end portion of the substrate 120. Pads 128a and 128b and wiring layers 129a, 129b, 129c, 129d, 129e, 129f and 129g are formed on the front surface of the substrate 120. Pairs of electrode units 124a and 124b, 124c and 124d and 124e and 124f are provided to hold the respective reaction cells therebetween. The wiring layers 129a to 129d are connected by bonding wires 127, and the wiring layers and the electrode units are also similarly connected by bonding wires. Such electrode units, wiring layers, pads and bonding wires are similarly formed on the back surface of the substrate 120, as partially shown in Fig. 12B. A pair of electrode units are provided to apply an electric field to the solution stored in the reaction cell 123b. An electrode 124g shown in the figure is one of such paired electrodes. In order to apply voltage to the electrode units, wiring layers 129h, 129i and the like are also formed on the back surface of the substrate 120, while the wiring layers and the electrode units are connected by a bonding wire 127. A pair of electrode units are also provided on another reaction cell provided on the back surface of the substrate 120. When the pads 128a and 128b is connected to an external power source, an electric field is applied across the pair of the electrode units provided for each reaction cell.

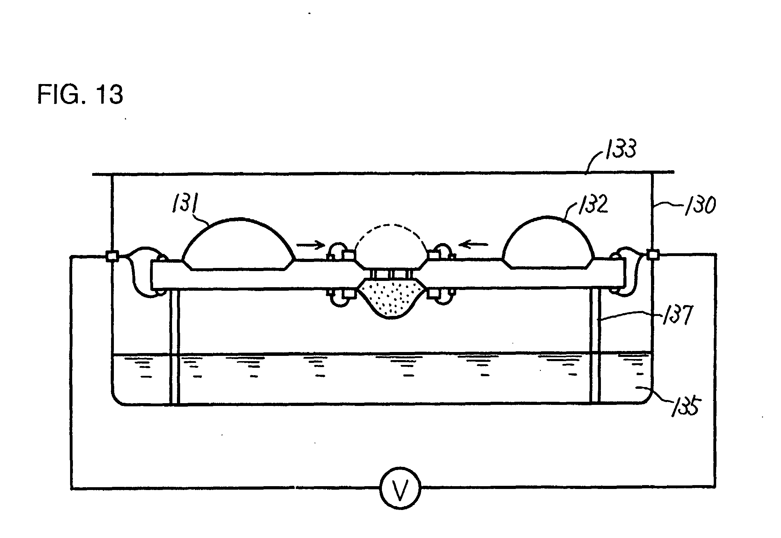

Fig. 13 schematically shows an example as to how to use the apparatus having the through holes as shown in Figs. 12A and 12B. The apparatus is supported by support legs 137 or the like, and placed in a container 130. A solution 135 such as a buffer solution is held on the bottom of the container 130, and an opening of the container 130 is sealed with a lid 133 for preventing the evaporation of the solution. A drop of a solution such as a buffer solution for controlling conditions of crystallization or a solution containing a substance such as protein to be crystallized is deposited on the solution cells of the apparatus horizontally held by the support legs 137. Each of droplets 131 and 132 held in the solution cells partially comes to flow into the reaction cells through the passage. The streamed solution moves to the reaction cells formed on the back surface of the apparatus through the through holes. Thus, a droplet hanging down in the direction of gravity is held in the reaction cell on the back surface. The solution moves due to the capillary phenomenon, to be held in each reaction cell. In such a state, voltage is applied to the respective electrodes provided on both the front and back surfaces to facilitate crystal nucleus formation from the solution held in the reaction cells.

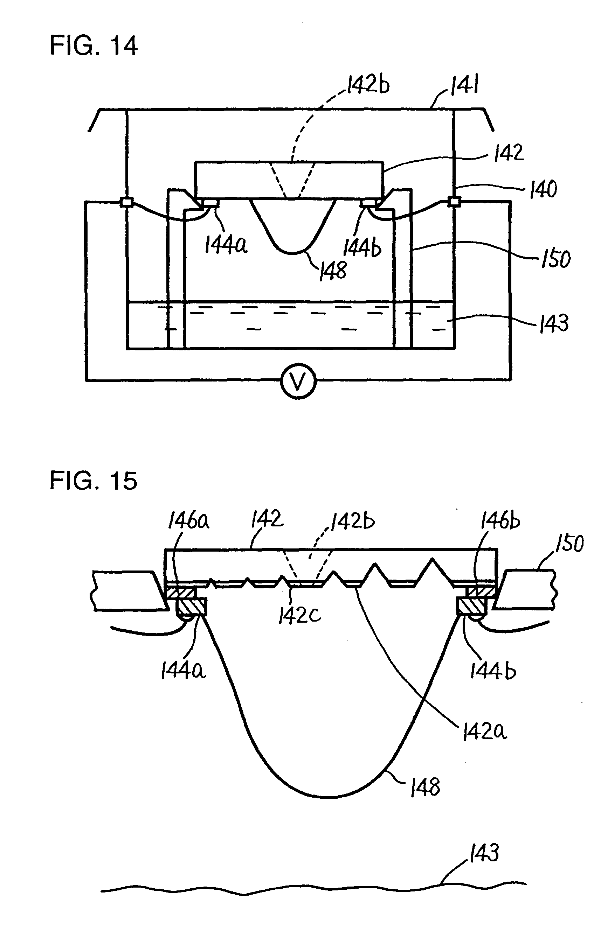

In the apparatus shown in Fig. 14, a solid-state component 142 having a through hole 142b is supported by a mounting 150 and placed in a container 140. An opening of the container 140 may be sealed with a lid 141. A droplet of a mother liquor containing the molecule to be crystallized is injected in the through hole 142b, and held on the solid-state component 142, hanging down in the direction of gravity. The container 140A hold, on the bottom, a precipitant 143 capable of absorbing the solvent vapor from the droplet held on the component 142, such as water vapor in the case of an aqueous solution, or a buffer solution 143 to keep the droplet in vapor-liquid equilibrium. A pair of electrodes 144a and 144b opposed to hold a droplet 148 are provided on the solid-state component 142. Voltage is placed between these electrodes from an external power source.

Fig. 15 shows the state of the droplet 148 held on the solid-state component 142 in an enlarged manner. The solid-state component 142 is held on the mounting 150 above the precipitant or the buffer solution 143. The solid-state component 142 is composed of a substrate (such as a p-type silicon substrate), and a silicon layer 142c in which the type or concentration of the impurity differs from that of the substrate (such as n-type silicon layer) formed thereon. The substrate also has a plurality of V-shaped grooves having different depths and widths formed thereon. Water-repellent layers 146a and 146b made of an electric insulating material (such as layers made of a water-repellent resin such as polyimide) are formed to enclose the grooves. The through hole 142b into which the mother liquor is injected is provided at a substantial center of the substrate. The opposed electrodes 144a and 144b are attached to the water-repellent layers 146a and 146b respectively. The solid-state component 142 is held on the mounting 150 with the V-groove side down. When a small amount of solution (mother liquor) containing the molecule such as protein to be crystallized is injected into the through hole 142b from the back side of the solid-state component with a pipette or the like, the mother liquor gradually shifts to the surface formed with the grooves, so that the droplet is formed on the surface. The injection of the mother liquor is ended when such a state is attained that the droplet does not drop but the liquid comes into all the grooves and is stably held thereon. Spreading of the mother liquor is stopped by the water-repellent layers 146a and 146b, and the droplet 148 is stably held in the state of it hanging down in the direction of gravity. In such a manner, a very small amount of the solution can be enough for the crystallization. An electric field is applied to the droplet 148 held between the pair of electrodes 144a and 144b. In such an apparatus, crystal nucleus formation is facilitated by the electric field, and crystal growth is induced inside the grooves.

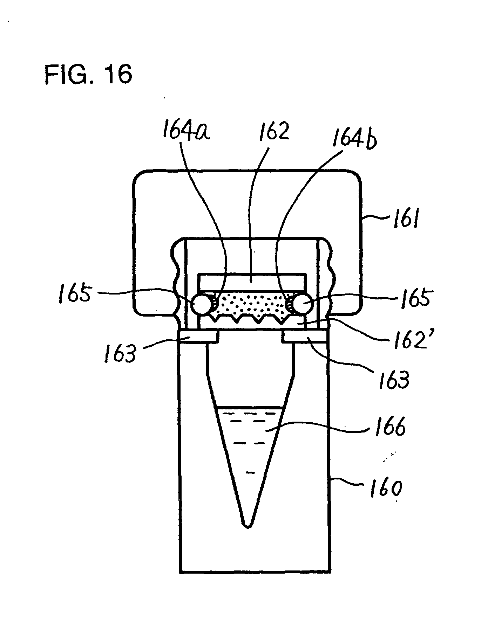

Fig. 16 shows an example of the apparatus enabling crystal growth with an extremely small quantity of mother liquor. An upper substrate 162 and a lower substrate 162' each forming the solid-state component are superposed through spacers 165. A plurality of grooves are formed on these substrates. Typically, the substrates 162 and 162' are such superposed that the longitudinal line of the groove on the upper substrate intersect with that of the groove on the lower substrate. The spacers 165 are provided with electrodes 164a and 164b respectively, so that an electric field can be applied to the solution held between the substrates 162 and 162'. The substrates are placed on a support 163 at an upper portion of a container 160. A small amount of a solution containing the molecule such as protein to be crystallized (mother liquor) is injected from the side into the space between the substrates 162 and 162' with a pipette or the like. When the mother liquor is stably held without dropping from the clearance between the substrates, the injection of the mother liquor is stopped. The bottom portion of the container 160 is previously filled with a buffer solution 166. The buffer solution 166 is used to keep the mother liquor in vapor-liquid equilibrium. The container 160 can be sealed with a cap 161. An electric field is applied to the mother liquor held between the substrates 162 and 162' through the counter electrodes 164a and 164b, so that crystal nucleus formation is promoted. After a crystal nucleus is formed, the crystal comes to grow in a groove or grooves formed on the substrates. In the apparatus shown in Fig. 16, the buffer solution 166a may be replaced with a desiccant for absorbing a solvent (such as water) from the mother liquor. The spacers 165 themselves may be used to form the electrodes.

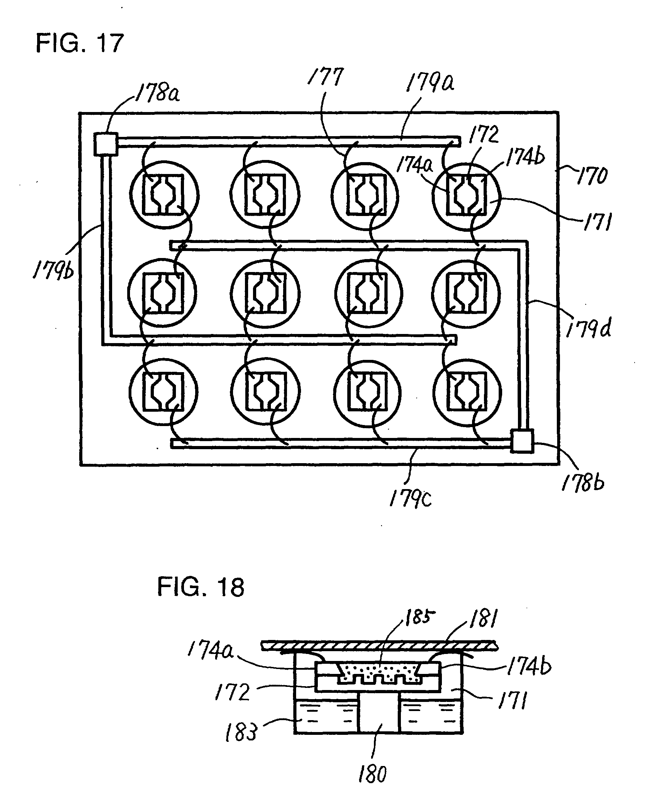

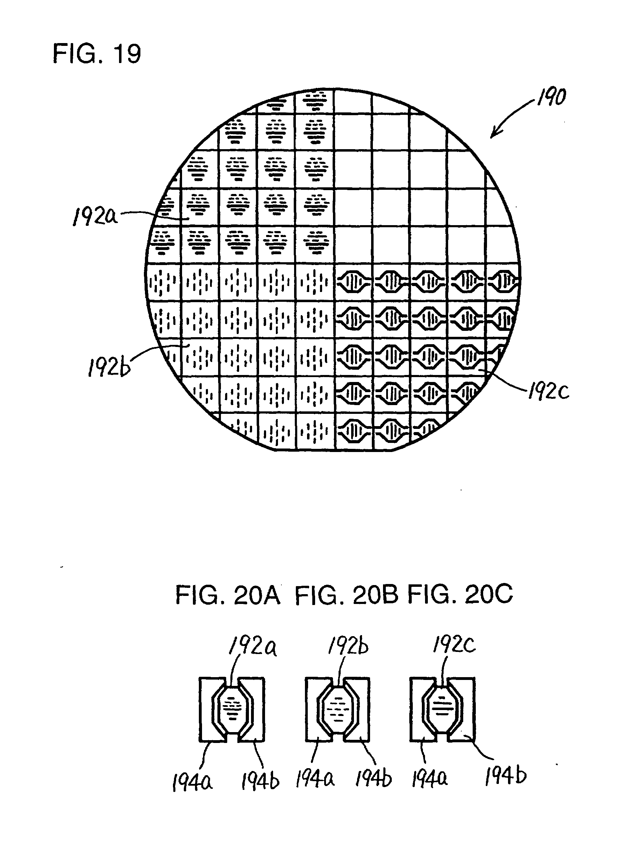

In the apparatus shown in Fig. 17, voltage can be simultaneously applied to a number of the apparatuses for crystal growth. A number of cylindrical wells 171 are arranged in a plate 170, and the apparatus for crystal growth is placed in each well 171. Pads 178a and 178b and wiring layers 179a, 179b, 179c and 179d are formed on the plate 170. A pair of counter electrodes 174a and 174b provided on a solid-state component 172 are connected to the wiring layers by bonding wires 177. Fig. 18 shows the apparatus for crystal growth placed in one of the wells. As the apparatus for crystal growth, the apparatus as shown in Fig. 5 or 6, or Figs. 20A to 20C or Fig. 21 described later may be employed. The apparatus for crystal growth is supported by a pedestal 180 in the well 171. The solid-state component 172 forming the apparatus for crystal growth consists of a silicon substrate into which an impurity is implanted, and islands, projections or grooves are formed on the surface. The pair of electrodes 174a and 174b are provided to enclose the islands, projections or grooves on the solid-state component 172. A precipitant 183 is held on the bottom of the well 171. After a solution 185 containing the molecule to be crystallized is placed in the space enclosed with the electrodes 174a and 174b on the solid-state component 172 with a pipette or the like, the opening of the well 171 is closed with a cover 181. When the pads 178a and 178b shown in Fig. 17 is connected to an external power source, voltage is placed between the counter electrodes 174a and 174b to facilitate the formation of crystal nuclei from the solution on the solid-state component 172.

In order to fabricate the solid-state component employed in the present invention, conventional techniques employed for the semiconductor device process may be employed as described in WO96/26781, WO97/49845 and WO98/02601. Specifically, a number of the solid-state components may be formed on a semiconductor substrate such as a silicon wafer by means of ion implantation, photolithography, etching and the like. Fig. 19 shows a number of the solid-state components formed on a silicon wafer. Three types of the solid-state components 192a, 192b and 192c are formed on a silicon wafer 190 by large numbers respectively. A plurality of grooves, islands or projections are formed on each solid-state component, along with an impurity layer for valence electron control. A region formed with the grooves, islands or projections defines a region for crystallization. The silicon wafer 190 is cut (scribed) to give a number of the solid-state components. As shown in Fig. 19, a plurality of types of the solid-state components may be formed on a single wafer, while a single type of the solid-state components may be formed on a single wafer by a large number.

The solid-state component obtained through the scribing is combined with the electrode units formed according to the process as shown in Fig. 8. The electrode units may be mounted on the solid-state component, or may be bonded to the solid-state component. A pair of the electrodes is provided on each of the three types of the solid-state components as shown in Fig. 19, so that three types of apparatuses for crystal growth are obtained as shown in Figs. 20A to 20C. The size of each apparatus obtained is 15 mm by 15 mm, for example. A pair of the electrode units 194a and 194b are provided on each of the solid-state components 192a, 192b and 192c. The electrode units 194a and 194b are provided to enclose the region having the grooves, islands or projections in the solid-state component.

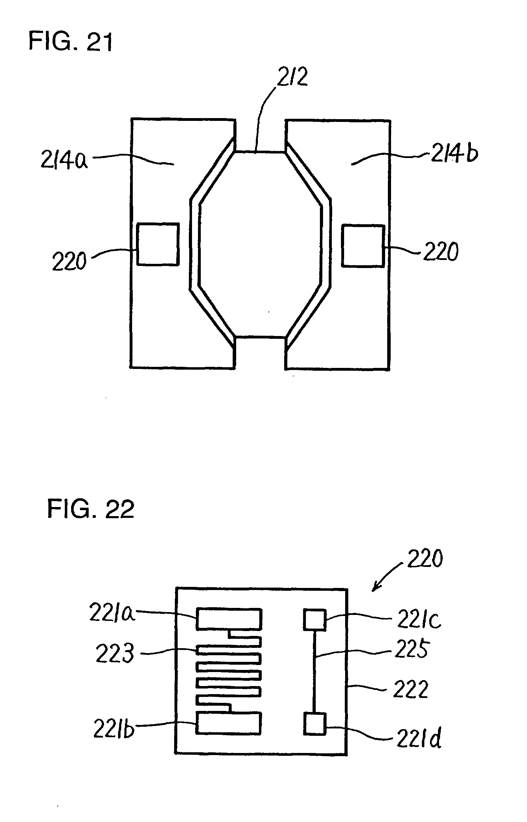

As shown in Fig. 21, heating elements 220 may also be provided on a pair of electrode units 214a and 214b respectively. The heating elements 220 can heat the solution held on a solid-state component 212. The heating further promotes the movement of the molecule to be crystallized in the solution. Crystal nucleus formation is accelerated by application of an electric field and heating. The heating elements 220 have a structure as shown in Fig. 22, for example. Pads 221a and 221b are formed on a base material 222, and a heating material 223 is provided between these pads. The pads 221a and 221b are formed of a good conductor such as copper or aluminum, and an electric heating material such as Cr, an Fe-Cr-Al based alloy or an N-Cr based alloy is used for the heating material 223. The heating element 220 is provided with a portion for measuring the heating temperature as needed. Such a portion comprises pads 221c and 221c and a resistance wire 225 for temperature measurement. Cr, a copper-nickel alloy, a copper-manganese alloy or the like is used for the resistance material. Electric resistivity of the resistance wire 225 depends on the temperature in a prescribed temperature range. Thus, the heating temperature by the heating material 223 can be determined by measuring the resistivity of the resistance wire 225. For example, the size of the apparatus for crystal growth as shown in Fig. 21 is 15 mm by 15 mm, and the size of the heating element is 2.5 mm by 2.5 mm.

The present invention can be used for crystallizing various macromolecular compounds, particularly macromolecular electrolytes. The present invention is preferably applied for crystallizing protein such as enzyme and membrane protein, polypeptide, peptide, polysaccharide, nucleic acid as well as composites and derivatives thereof. The present invention is preferably applied for crystallization of a biological macromolecule.

### Industrial Applicability

According to the present invention, as hereinabove described, it is possible to promote crystal nucleus formation and accelerate crystal growth by applying an electric field to the solution containing the molecule to be crystallized. According to the present invention, a biological macromolecule such as protein otherwise hard to be crystallized in a large size can be formed into a large-sized crystal that allows an X-ray structural analysis. The present invention is applied to study, development and preparation of useful substances, particularly biological macromolecules such as protein and nucleic acid in pharmaceutical industry, food industry and the like. Further, the present invention is applied to refining or crystallization of molecules of interest.

## Claims

1. A method of growing a crystal of a macromolecular compound contained in a solution, comprising the steps of:
providing a solid-state component having a region whose valence electrons have previously been controlled so as to control the concentration of holes or electrons on a surface portion of the region in response to the environment of the solution containing the macromolecular compound;
holding the solution containing the macromolecular compound on the region of the solid-state component whose valence electrons have previously been controlled; and
applying an electric field to the held solution across a pair of opposed electrodes, wherein
a crystal of the macromolecular compound is produced from the solution to which the electric field is applied, under an electric state generated on the surface of the solid-state component by the previously controlled valence electrons.

2. The method according to claim 1, wherein the concentration of holes or electrons present at a surface of the solid-state component has previously been controlled, and the solution containing the macromolecular compound is held on the surface of the solid-state component.

3. The method according to claim 1, wherein the solid-state has previously been modified to have regions of varying electric potentials on a surface thereof, and the solution containing the macromolecular compound is held on the surface of thereof.

4. The method according to any one of claims 1 to 3, wherein the region whose valence electrons have previously been controlled or the surface of the solid-state component comprises a semiconductor to which an impurity is added.

5. A method of growing a crystal of a macromolecular compound contained in a solution, comprising the steps of:
doping a surface of a solid-state component with an impurity to modify the concentration of holes or electrons present at the surface of the solid-state component;
holding the solution containing the macromolecular compound on the surface of the solid-state component; and
applying an electric field to the held solution across a pair of opposed electrodes, wherein
a crystal of the macromolecular compound is produced from the solution to which the electric field is applied, under an electric potential generated on the surface of the solid-state component.

6. The method according to claim 5, wherein the surface of the solid-state component comprises a semiconductor to which an impurity is added.

7. An apparatus for growing a crystal of a macromolecular compound contained in a solution, comprising:
a solid-state component having a region whose valence electrons have previously been controlled so as to control the concentration of holes or electrons on a surface portion of the region in response to the environment of the solution containing the macromolecular compound;
a pair of opposed electrodes provided to hold therebetween a space above the region whose valence electrons have previously been controlled; and
an electric insulating material provided between the solid-state component and the pair of the opposed electrodes.

8. The apparatus according to claim 7, wherein the concentration of holes or electrons present at a surface of the solid-state component has previously been modified, and the pair of the electrodes are provided to hold therebetween a space above the surface.

9. The apparatus according to claim 7, wherein the solid-state component has previously been modified to have regions of varying electric potentials on a surface thereof, and the pair of the electrodes are provided to hold therebetween a space above the surface.

10. The apparatus according to any one of claims 7 to 9, wherein a space for holding the solution containing the macromolecular compound is formed by the pair of the opposed electrodes and the electric insulating material above the region whose valence electrons have previously been controlled or the surface of the solid-state component.

11. The apparatus for crystal growth according to any one of claims 7 to 10, wherein the pair of the opposed electrodes is made of a conductive material in the form of a thin film.

12. The apparatus for crystal growth according to any one of claims 7 to 11, wherein the region whose valence electrons have previously been controlled or the surface of the solid-state component is made of a semiconductor to which an impurity is added.

13. An apparatus for growing a crystal of a macromolecular compound contained in a solution, comprising:
a solid-state component having a surface to be used for growing the crystal of the macromolecular compound and comprising a silicon substrate cut into a desired shape;
a plurality of islands formed on a certain region of the surface of the solid-state component to be used for growing the crystal of the macromolecular compound at the top thereof or at the vicinity of the top;
a wall provided on the solid-state component to surround the plurality of the islands for holding the solution on the region formed with the islands; and
a pair of opposed electrodes, which are electrically isolated from the solid-state component and formed on a islands'-side surface of the wall.

14. The apparatus according to claim 13, further comprising an ac power source or a dc power source capable of switching between positive and negative polarities, connected to the pair of the opposed electrodes.

15. The apparatus according to claim 13, wherein
the wall comprises an insulating substrate formed in a desired shape and a semi-conductive substrate which is bonded to the insulating substrate and has a similar shape to the insulating substrate,
the wall is provided on the solid-state component so that the insulating substrate is in contact with the solid-state component, and
the pair of the opposed electrodes are formed on the semi-conductive substrate of the wall electrically isolated from the solid-state component by the insulating substrate.
